# EUROPÄISCHE PATENTSCHRIFT

(11) **EP 3 108 491 B1**
(45) Veröffentlichungstag und Bekanntmachung des Hinweises auf die Patenterteilung: **01.07.2020**
(21) Anmeldenummer: 15705278.8
(22) Anmeldetag: 13.02.2015
(51) Int. Cl.: H01H 9/00, H01H 9/52, H01F 29/04

(54) **SCHALTEINRICHTUNG**
SWITCHING UNIT
DISPOSITIF DE COMMUTATION

(30) Priorität: 21.02.2014 DE 102014102262
(43) Veröffentlichungstag der Anmeldung: 28.12.2016
(73) Patentinhaber: Maschinenfabrik Reinhausen GmbH, 93059 Regensburg (DE)
(72) Erfinder: REICH, Alexander, 93098 Mintraching (DE); FLOTZINGER, Simon, 93089 Aufhausen (DE); UNTERREINER, Nikolaus, 93059 Regensburg (DE)
(86) Internationale Anmeldenummer: PCT/EP2015/053126
(87) Internationale Veröffentlichungsnummer: WO 2015/124511

(56) Entgegenhaltungen:
- EP-A2- 0 660 496
- EP-A2- 0 971 408
- CH-A5- 578 276
- DE-A1- 2 051 151
- DE-A1- 2 303 550
- DE-A1- 2 902 771
- DE-A1- 4 420 564
- DE-A1- 19 805 820
- DE-B3-102008 027 274
- DE-C- 695 679
- DE-U1- 8 801 086

## Beschreibung

Die Erfindung betrifft eine Schalteinrichtung mit einem Schaltmodul und einem Kühlkanal.

DE2303550 A1 zeigt eine Schalteinrichtung für einen Wähler oder Umsteller, umfassend: ein Gehäuse, ein Schaltmodul, das im Inneren des Gehäuses angeordnet ist und mehrere Schaltelemente aufweist; eine Isolierflüssigkeit im Inneren des Gehäuses, die das Schaltmodul umgibt; einen Kühlkreislauf, der eine Pumpe, Kühlkanäle und einen Wärmetauscher aufweist, wobei das Innere des Gehäuses und der Kühlkreislauf hydraulisch miteinander verbunden sind derart, dass die Isolierflüssigkeit sowohl im Kühlkreislauf zur Kühlung des Schaltmoduls als auch im Inneren des Gehäuses als Isoliermittel verwendet wird.

Aufgabe der Erfindung ist es, eine Schalteinrichtung mit einem Schaltmodul bereitzustellen, bei der die Kühlung einfach, kostengünstig und wartungsfreundlich aufgebaut ist.

Diese Aufgabe wird mit einer Schalteinrichtung gemäß dem unabhängigen Anspruch gelöst. Die Merkmale der Unteransprüche bilden dabei vorteilhafte Weiterbildungen der Erfindung.

Die Erfindung schlägt eine Schalteinrichtung gemäß dem unabhängigen Anspruch 1 vor. Weitere Ausgestaltungen ergeben sich aus den Unteransprüchen.

Durch eine hydraulische Verbindung zwischen dem Kühlkreislauf und dem Inneren des Gehäuses, in dem das mindestens eine Schaltmodul angeordnet ist, kann die selbe Isolierflüssigkeit zum Kühlen der Schaltelemente und zum Isolieren der Schaltmodule verwendet werden. Mögliche Leckagen im Kühlkanal wirken sich durch die Verwendung ein und derselben Isolierflüssigkeit weniger schlimm auf die Schalteinrichtung aus, als beispielsweise bei unterschiedlichen Isolierflüssigkeiten und Kühlflüssigkeiten, beispielsweise Wasser. Eine Vermischung der unterschiedlichen Flüssigkeiten, z.B. Wasser und Öl, kann verheerende Folgen haben. Auch die Wartung wird dadurch erheblich erleichtert. Hier muss lediglich eine Isolierflüssigkeit getauscht werden, anstatt zwei. Kleine Leckagen im Kühlkanal werden durch die hydraulische Verbindung ausgeglichen, sodass keine sofortige Wartung und damit Stilllegung der Schalteinrichtung erzwungen wird.

Die Schalteinrichtung ist als Stufenschalter für Stufentransformatoren im Nieder-, Mittel- und Hochspannungsbereich, oder als Stufenschalter für Stufentransformatoren in Energienetz- oder Schmelzofenanwendungen ausgebildet.

Das Schaltmodul der Schalteinrichtung kann auf beliebige Art und Weise ausgebildet sein, und beispielsweis aus Halbleiterscheibenzellen, insbesondere als Thyristor, IGBT's, etc. bestehen.

Die Isolierflüssigkeit kann auf beliebige Art und Weise ausgebildet sein, beispielsweise als Isolieröl oder Esterflüssigkeit.

Die Schalteinrichtung kann beliebig viele Schaltmodule enthalten, vorzugsweise ein Schaltmodul für jede zu beschaltende Phase eines Stufentransformators.

Die Verbindung zwischen dem Inneren des Gehäuses und dem Kühlkreislauf kann auf beliebige Art und Weise ausgebildet sein, beispielsweise kann diese im Ausdehner außerhalb der Schalteinrichtung angeordnet werden.

Es kann vorgesehen sein, dass
- das Schaltmodul mindestens eine Kühldose umfasst, in der die ihm zugeordneten Kühlkanäle ausgebildet sind;
- jede Kühldose einen Eingang zum Einleiten und einen Ausgang zum Ausleiten der Isolierflüssigkeit aufweist;
- jede Kühldose und das zugeordnete Schaltelement thermisch, elektrisch und mechanisch miteinander verbunden sind.

Die Kühldosen sind aus einem elektrisch sowie thermisch leitfähigen Material, wie z.B. Aluminium, ausgebildet. Die Kühlkanäle durchziehen das Innere der Kühldosen beispielsweise in Mäanderform.

Es kann vorgesehen sein, dass
- jedes Schaltmodul mindestens eine Schaltmodulsäule aufweist;
- jede Schaltmodulsäule mindestens eine Kühldose und mindestens ein Schaltelement umfasst, die übereinander angeordnet und thermisch, mechanisch und elektrisch leitend miteinander verbunden sind.

Die Schaltelemente können auf beliebige Art und Weise ausgebildet sein und beispielsweise einzeln oder in Gruppen elektrisch beschaltet werden. In den Gruppen sind die Schaltelemente elektrisch in Reihe oder parallel verschaltet. Das Schaltmodul kann beliebig viele Schaltmodulsäulen enthalten.

Es kann vorgesehen sein, dass
- jede Schaltmodulsäule zwischen einer oberen Vorspannplatte und einer unteren Vorspannplatte angeordnet ist.

Es kann vorgesehen sein, dass
- jede obere Vorspannplatte und die zugeordnete untere Vorspannplatte über Spannsäulen mechanisch miteinander verbunden sind;
- die Spannsäulen hohl ausgebildet sind;
- eine obere Verteilerplatte über der oberen Vorspannplatte angeordnet ist und mit dieser mechanisch verbunden ist;
- eine untere Verteilerplatte unter der unteren Vorspannplatte angeordnet ist und mit dieser mechanisch verbunden ist;
- die Spannsäulen mit den Kühlkanälen hydraulisch verbunden sind,
- die untere Verteilerplatte und mindestens eine der Spannsäulen als Vorlauf dient, um durch sie die Isolierflüssigkeit in die Kühlkanäle einzuleiten;
- die obere Verteilerplatte und mindestens eine der anderen Spannsäulen als Rücklauf dient, um durch sie die Isolierflüssigkeit aus den Kühlkanälen auszuleiten.

Die hydraulische Verbindung zwischen den Spannsäulen und den Kühlkanälen kann über mindestens eine Kühldose, die über Leitungen mit einer Spannsäule verbunden ist, realisiert werden. Der Kühlkanal kann beispielsweise über parallel oder in Reihe hydraulisch verbundene Kühldosen ausgebildet sein.

Die Spannsäulen und die Verteilplatten können auf beliebige Art und Weise ausgebildet sein, beispielsweise aus einem hoch festen, elektrisch isolierenden Material wie GFK.

Es kann vorgesehen sein, dass
- das Innere des Gehäuses und der Kühlkreislauf über einen Ausdehner miteinander verbunden sind.

Es kann vorgesehen sein, dass
- das Schaltmodul vier Schaltmodulsäulen aufweist;
- bei jeder Schaltmodulsäule mindestens eine der Spannsäulen als Vorlauf und mindestens eine der anderen Spannsäulen als Rücklauf vorgesehen sind.

Es kann vorgesehen sein, dass
- die Schaltmodulsäulen mittels einer Druckverteileinheit im Schaltmodul gehaltert werden.

Es kann vorgesehen sein, dass
- die Schalteinrichtung ein Stufenschalter zur Spannungsregelung an einem Stufentransformator mit einer Regelwicklung ist.

Nachfolgend sind die Erfindung und ihre Vorteile unter Bezugnahme auf die beigefügten Zeichnungen ausführlicher beschrieben. Es zeigen:
- Fig. 1: eine Schalteinrichtung mit einem Kühlkreislauf;
- Fig. 2: einen Ausschnitt eines Schaltmoduls;
- Fig. 3: ein Schaltmodul;
- Fig. 4: ein Schaltmodul im Schnitt (B - B);
- Fig. 5: ein Schaltmodul in einem Gehäuse;
- Fig. 6: eine Druckverteileinheit eines Schaltmoduls.

Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die erfindungsgemäße Schalteinrichtung sein kann und stellen somit keine abschließende Begrenzung der Erfindung dar.

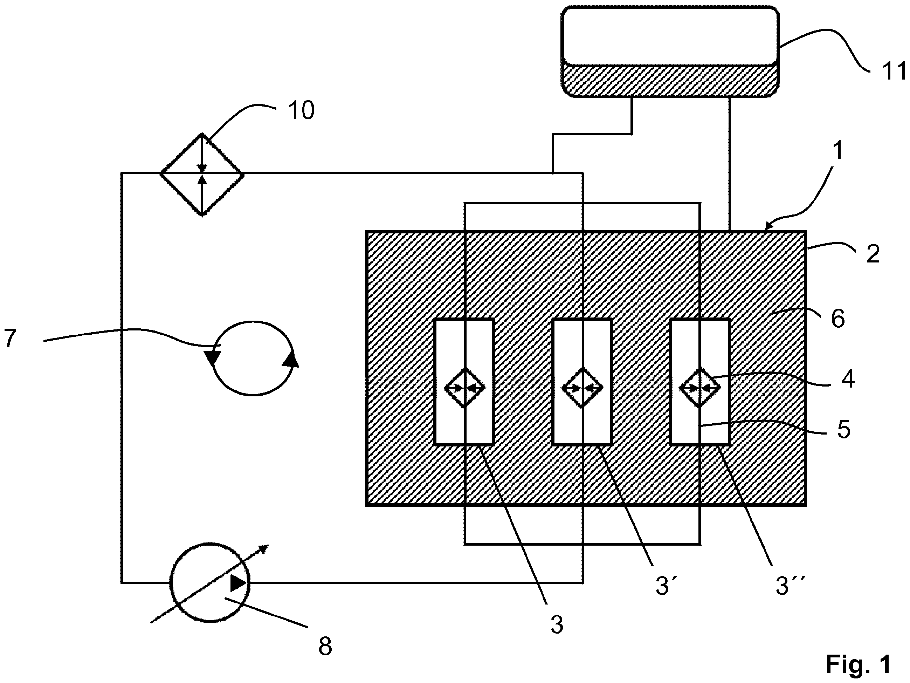

**Fig. 1** zeigt eine Schalteinrichtung 1, insbesondere einen Laststufenschalter zur Spannungsregelung an einem Regeltransformator mit einer Regelwicklung mit einem Kühlkreislauf 7. Die Schalteinrichtung 1 umfasst ein Gehäuse 2, welches mit einer Isolierflüssigkeit 6 gefüllt ist. Im Inneren des Gehäuses 2 sind drei Schaltmodule 3, 3', 3" angeordnet. Jedes Schaltmodul 3, 3', 3" weist mindestens ein Schaltelement 4 und mindestens einen Kühlkanal 5 auf. Jeder Kühlkanal 5 ist ein Teil des Kühlkreislaufs 7. Weiterhin sind im Kühlkreislauf 7 ein Wärmetauscher 10 und eine Pumpe 8 angeordnet. Das Innere des Gehäuses 2 und der Kühlkreislauf 7 sind miteinander hydraulisch verbunden, d.h. ein Austausch der Isolierflüssigkeit 6 zwischen dem Kühlkreislauf 7 und dem Inneren des Gehäuses 2 ist möglich. In der hier dargestellten Ausführungsform wird die Verbindung zwischen dem Inneren des Gehäuses 2 und dem Kühlkreislauf 7 über einen Ausdehner 11 realisiert. Die Isolierflüssigkeit 6 ist vorzugsweise als ein Ester oder Isolieröl ausgebildet, der sowohl im Kühlkreislauf 7 zur Kühlung eines jeden Schaltmoduls 3, 3', 3" als auch im Inneren des Gehäuses 2 als Isoliermittel verwendet wird. Das Schaltelement 4 ist eine Halbleiterscheibenzelle und kann z.B. als Thyristor, IGBT, etc. ausgebildet sein.

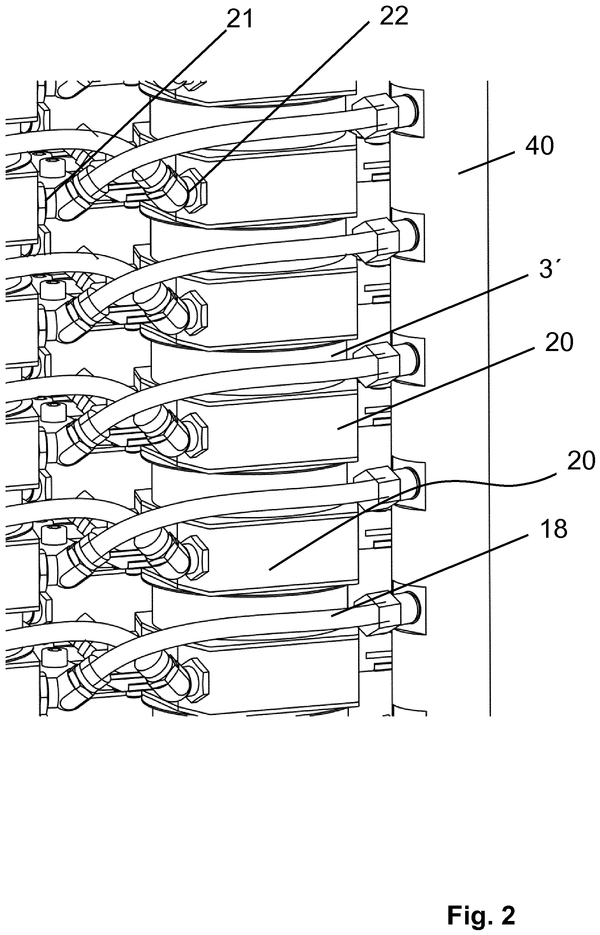

**Fig. 2** zeigt einen Ausschnitt eines Schaltmoduls 3, insbesondere mehrere Schaltelemente 4 und Kühldosen 20, die abwechselnd mechanisch, thermisch und elektrisch miteinander verbunden sind. Im Inneren einer jeden Kühldose 20 ist der Kühlkanal 5 eingebracht, durch den die Isolierflüssigkeit 6 zum Kühlen des Schaltelementes 4 befördert wird. Die Kühldosen 20 haben hierfür jeweils einen Eingang 21 zum Einleiten der Isolierflüssigkeit 6 und einen Ausgang 22 zum Ausleiten der Isolierflüssigkeit 6.

Die Schaltelemente 4 können einzeln oder in Gruppen elektrisch beschaltet werden. In den Gruppen sind die Schaltelemente 4 in Reihe oder parallel verschaltet.

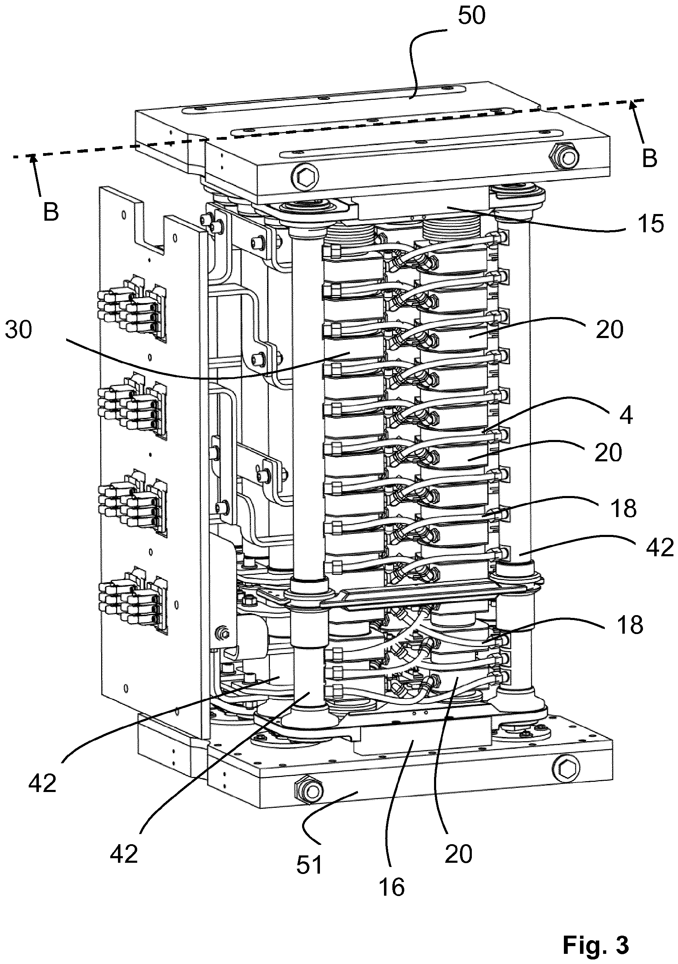

Fig. 3 zeigt das gesamte Schaltmodul 3. Dieses weist vier Schaltmodulsäulen 30 auf, die jeweils aus mehreren übereinander gestapelten, mechanisch, thermisch und elektrisch verbundenen Schaltelementen 4 und Kühldosen 20 mit darin eingebrachte Kühlkanälen 5, aufgebaut sind. Die Kühlkanäle 5 der einzelnen Kühldosen 20 sind untereinander hydraulisch über Leitungen 18 verbunden. Die Schaltmodulsäulen 30 sind zwischen einer oberen Vorspannplatte 15 und einer unteren Vorspannplatte 16 angeordnet. Weiterhin sind zwischen den Vorspannplatten 15, 16 acht Spannsäulen 42 positioniert. Diese Spannsäulen 42 sind mit den Vorspannplatten 15, 16 mechanisch verbunden und bilden das Gerüst des Schaltmoduls 3. Die Spannsäulen 42 sind vorzugsweise als GFK-Rohre ausgebildet und somit innen hohl und elektrisch isolierend. Die Spannsäulen 42 sind außerdem über Leitungen 18 mit den Kühldosen 20 verbunden. Die Kühldosen 20 sind miteinander in Reihe oder parallel hydraulisch verbunden.

Über der oberen Vorspannplatte 15 ist eine obere Verteilerplatte 50 und unter der unteren Vorspannplatte 16 eine untere Verteilerplatte 51 angeordnet. Die obere, als Rücklauf 61 dienende Verteilerplatte 50 weist im Inneren Kanäle auf, die einerseits mit den Spannsäulen 42 und andererseits mit dem Wärmetauscher 10 bzw. der Pumpe 8 des Kreislaufs 7 hydraulisch verbunden sind. Auch die untere, als Vorlauf 61 dienende Verteilerplatte 51 weist im Inneren Kanäle auf, die einerseits mit den Spannsäulen 42 und andererseits mit dem Wärmetauscher 10 bzw. der Pumpe 8 des Kreislaufs 7 verbunden sind. Die untere Verteilerplatte 51 dient zusätzlich der Lagerung des Schaltmoduls 3. Da beide Verteilerplatten 50, 51 aus Kunststoff bestehen, dienen diese gleichzeitig zur Isolation des Schaltmodules 3 gegenüber dem am Gehäuse 2 liegenden Potential.

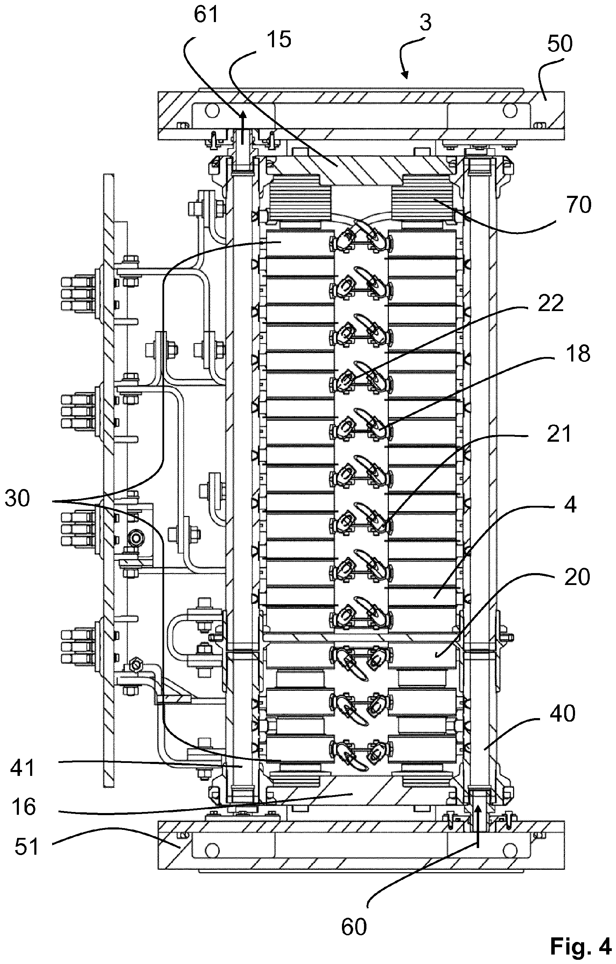

**Fig. 4** zeigt eine Schnittansicht **B** - **B** des Schaltmoduls 3 aus **Fig. 3****.** Dabei ist eine erste Spannsäule 40 mechanisch und hydraulisch mit der unteren Vorspannplatte 16 verbunden. Zusätzlich ist die erste Spannsäule 40 über mehrere Leitungen 18 mit den Kühlkanälen 5, die in den Kühldosen 20 eingebracht sind, hydraulisch verbunden. Die zweite Spannsäule 41 ist mechanisch und hydraulisch mit der oberen Vorspannplatte 15 verbunden. Zusätzlich ist die zweite Spannsäule 41 ebenfalls über mehrere Leitungen 18 mit den Kühlkanälen 5, die in den Kühldosen 20 eingebracht sind, mechanisch und hydraulisch verbunden. Somit kann das gesamte Schaltmodul 3 als ein Kühlkanal 5 angesehen wird. Die Kühldosen 20 können dabei parallel oder in Reihe zueinander zwischen zwei Spannsäulen 40, 41 hydraulisch verbunden sein.

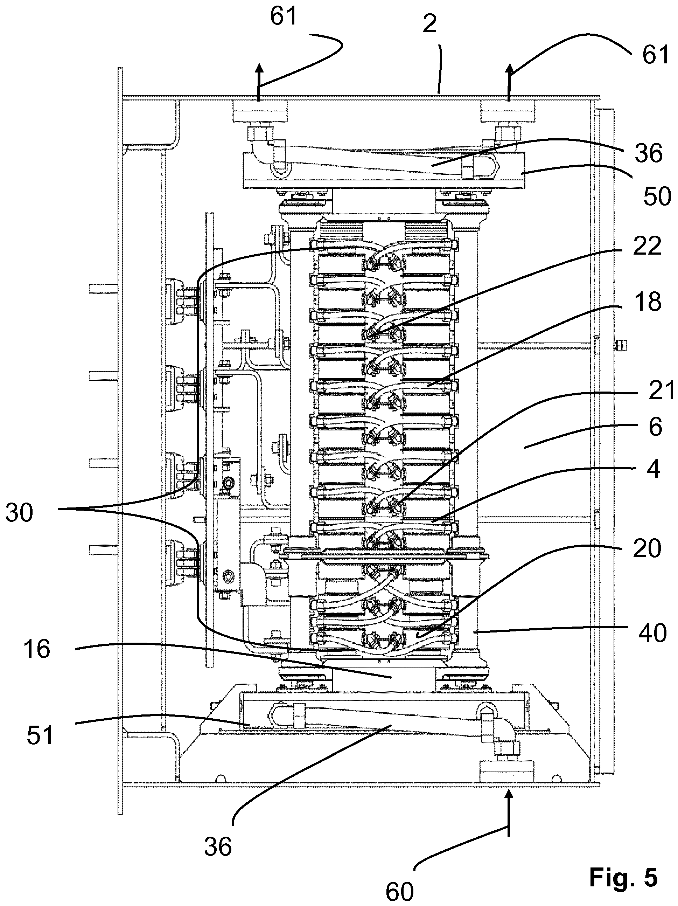

**Fig. 5** zeigt ein Schaltmodul 3 im Gehäuse 2 der Schalteinrichtung 1. Hier sind der Rücklauf 61 und der Vorlauf 60, insbesondere die obere und unter Verteilerplatten 50, 51, über Rohrleitungen 36 mit der außerhalb des Gehäuses 2 angeordneten Pumpe 8 und dem Wärmetauscher 10 verbunden. Das Schaltmodul 3 ist hier von der Isolierflüssigkeit 6 umgeben.

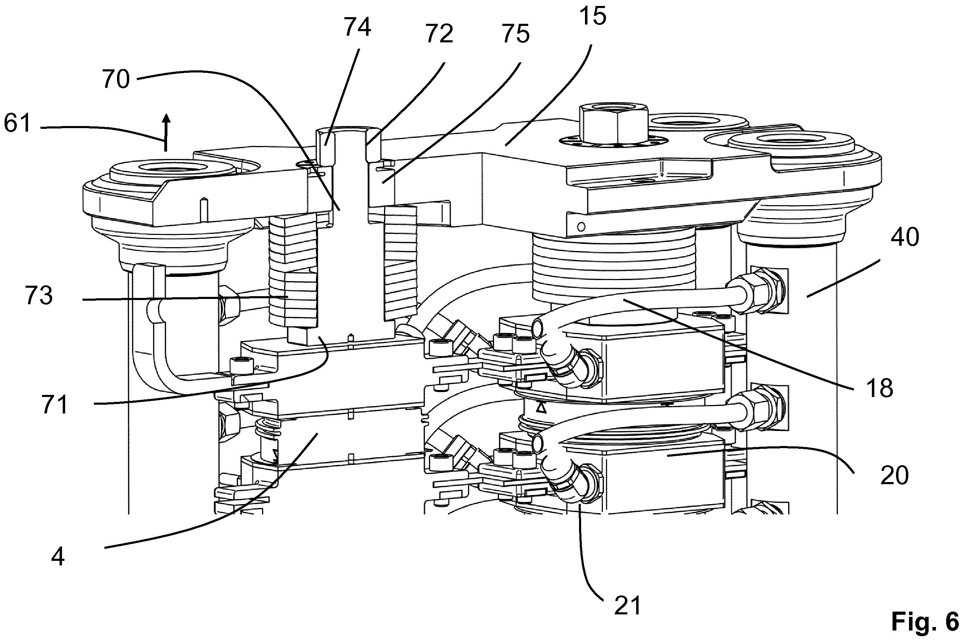

**Fig. 6** zeigt eine detaillierte Ansicht des Schaltmoduls 3. Um die Schaltmodulsäulen 30 im Schaltmodul 3 fixieren zu können, wird eine Druckverteileinheit 70 zwischen der obersten Kühldose 20 und der oberen Vorspannplatte 15 eingebracht. Die Druckverteileinheit 70 weist in dem an der Kühldose 20 angeordneten Bereich einen Flansch 71 auf. Der obere Bereich der Druckverteileinheit 70 weist ein Gewinde 72 auf, an dessen oberen Ende eine Schraubenmutter 74 angeordnet ist. Zwischen dem Flansch 71 und der Schraubenmutter 74 sind Tellerfedern 73 und eine Tellerfedernauflage 75 angeordnet. Die Druckverteileinheit 70 wird vorab unter einer Presse auf eine definierte, für das Schaltmodul 3 benötigte, Vorspannkraft eingestellt. Die Tellerfedern 73 werden beim Verspannen über die Tellerfedernauflage 75 gegen den Flansch 71 gedrückt und mit der Schraubenmutter 74 arretiert. Die Druckverteileinheit 70 wird über die Tellerfedernauflage 75 in die Vorspannplatte 15 eingeschraubt, bis die Druckverteileinheit 70 an der obersten Kühldose 20 der jeweiligen Schaltmodulsäule 30 anliegt. Die Druckverteileinheit 70 wird anschließend arretiert und gegen Verdrehen gesichert. Durch Lösen der Schraubenmutter 74 wird die definierte Vorspannung der Tellerfedern 73 auf die Schaltmodulsäule 30 übertragen.

Da jede Schaltmodulsäule 30 über eine separate Druckverteileinheit 70 verspannt wird, sind die beiden Schaltmodulsäulen 30 mechanisch voneinander entkoppelt und Höhenunterschiede können somit kompensiert werden.

### Bezugszeichenliste

- 1: Schalteinrichtung
- 2: Gehäuse
- 3, 3', 3": Schaltmodul
- 4: Schaltelement
- 5: Kühlkanal
- 6: Isolierflüssigkeit
- 7: Kühlkreislauf
- 8: Pumpe
- 10: Wärmetauscher
- 11: Ausdehner
- 15: obere Vorspannplatte
- 16: untere Vorspannplatte
- 18: Leitungen
- 20: Kühldose
- 21: Eingang
- 22: Ausgang
- 30: Schaltmodulsäule
- 36: Rohrleitungen
- 40: erste Spannsäule
- 41: zweite Spannsäule
- 42: Spannsäulen
- 50: obere Verteilerplatte
- 51: untere Verteilerplatte
- 60: Vorlauf
- 61: Rücklauf
- 70: Druckverteileinheit
- 71: Flansch
- 72: Gewinde
- 73: Tellerfedern
- 74: Schraubenmutter
- 75: Tellerfedernauflage

## Patentansprüche

1. Schalteinrichtung (1), die als Stufenschalter ausgebildet ist, umfassend:
- ein Gehäuse (2);
- ein Schaltmodul (3, 3',3"), das im Inneren des Gehäuses (2) angeordnet ist und mehrere Schaltelemente (4) und Kühldosen (20) mit darin eingebrachten Kühlkanälen (5) aufweist, wobei die Kühlkanäle der einzelnen Kühldosen (20) untereinander hydraulisch über Leitungen (18) verbunden sind;
- eine Isolierflüssigkeit (6) im Inneren des Gehäuses (2), die das Schaltmodul (3, 3', 3") umgibt;
- einen Kühlkreislauf (7), der eine Pumpe (8), die Kühlkanäle (5) und einen Wärmetauscher (10) aufweist;
wobei:
- das Innere des Gehäuses (2) und der Kühlkreislauf (7) hydraulisch miteinander verbunden sind derart, dass die Isolierflüssigkeit (6) sowohl im Kühlkreislauf (7) zur Kühlung des Schaltmoduls (3, 3', 3") als auch im Inneren des Gehäuses (2) als Isoliermittel verwendet wird.

2. Schalteinrichtung (1) nach dem vorigen Anspruch, wobei
- die Kühldosen (20) und das Schaltelement (4) thermisch leitend miteinander verbunden sind.

3. Schalteinrichtung (1) nach dem vorigen Anspruch, wobei
- das Schaltmodul (3, 3', 3") eine Schaltmodulsäule (30) aufweist;
- die Schaltmodulsäule (30) mehrere Kühldosen (20) und Schaltelemente (4) umfasst, die übereinander angeordnet und thermisch leitend miteinander verbunden sind.

4. Schalteinrichtung (1) nach dem vorigen Anspruch, wobei
- die Schaltmodulsäule (30) zwischen einer oberen Vorspannplatte (15) und einer unteren Vorspannplatte (16) angeordnet ist.

5. Schalteinrichtung (1) nach dem vorigen Anspruch, wobei
- die obere Vorspannplatte (15) und die untere Vorspannplatte (16) über Spannsäulen (42) mechanisch miteinander verbunden sind;
- die Spannsäulen (42) hohl ausgebildet sind;
- eine obere Verteilerplatte (50) über der oberen Vorspannplatte (15) angeordnet ist und mit dieser mechanisch verbunden ist;
- eine untere Verteilerplatte (51) unter der unteren Vorspannplatte (16) angeordnet ist mit dieser mechanisch verbunden ist;
- die Spannsäulen (42) mit den Kühlkanälen (5) hydraulisch verbunden sind,
- die untere Verteilerplatte (51) und eine der Spannsäulen (42) als Vorlauf (60) dienen, um durch sie die Isolierflüssigkeit (6) in die Kühlkanäle (5) einzuleiten;
- die obere Verteilerplatte (50) und eine der anderen Spannsäulen (42) als Rücklauf (61) dient, um durch sie die Isolierflüssigkeit (6) aus den Kühlkanälen (5) auszuleiten.

6. Schalteinrichtung (1) nach einem der vorigen Ansprüche, wobei
- das Innere des Gehäuses (2) und der Kühlkreislauf (7) über einen Ausdehner (11) miteinander verbunden sind.

7. Schalteinrichtung (1) nach einem der vorigen Ansprüche, wobei
- das Schaltmodul (3, 3',3") vier Schaltmodulsäulen (30) aufweist;
- bei jeder Schaltmodulsäule (30) eine der Spannsäulen (42) als Vorlauf (60) und eine andere der Spannsäulen (42) als Rücklauf (61) vorgesehen sind.

8. Schalteinrichtung (1) nach einem der vorigen Ansprüche, wobei
- die Schaltmodulsäulen (30) mittels einer Druckverteileinheit (70) im Schaltmodul (3, 3', 3") gehaltert werden.

9. Schalteinrichtung (1) nach einem der vorigen Ansprüche, wobei
- die Schalteinrichtung (1) ein Laststufenschalter zur Spannungsregelung an einem Stufentransformator mit einer Regelwicklung ist.

## Claims

1. Switching device (1), comprising:
- a housing (2);
- a switching module (3, 3', 3") which is arranged inside the housing (2) and has several switching elements (4) and a cooling boxes (20) with cooling channel (5) enclosed therein, wherein the cooling channels (5) of the various cooling boxes (20) being hydraulically connected to one another via lines (18);
- an insulating liquid (6), which surrounds the switching module (3, 3', 3"), inside the housing (2); and
- a cooling circuit (7) comprising a pump (8), the cooling channel (5) and a heat exchanger (10);
wherein:
- the inside of the housing (2) and the cooling circuit (7) are hydraulically connected to each other in such way that the insulating liquid (6) is used in the cooling circuit (7) for cooling the switching modules (3, 3', 3") and also inside the housing (2) as insulating medium.

2. Switching device (1) according to the preceding claim, wherein
- the switching module (3, 3', 3") comprises a cooling box (20) in which the cooling channel (5) is formed; and
- the cooling box (20) and the switching element (4) are thermally conductively connected together.

3. Switching device (1) according to the preceding claim, wherein
- the switching module (3, 3', 3") comprises a switching module column (30); and
- the switching module column (30) comprises a cooling box (20) and a switching element (4) which are arranged one above the other and thermally conductively connected together.

4. Switching device (1) according to the preceding claim, wherein
- the switching module column (30) is arranged between an upper preloading plate (15) and a lower preloading plate (16).

5. Switching device (1) according to the preceding claim, wherein
- the upper preloading plate (15) and the lower preloading plate (16) are mechanically connected together by way of clamping columns (42);
- the clamping columns (42) are of hollow construction;
- an upper distributor plate (50) is arranged above the upper preloading plate (15) and is mechanically connected therewith;
- a lower distributor plate (51) is arranged below the lower preloading plate (16) and is mechanically connected therewith;
- the clamping columns (42) are hydraulically connected with the cooling channels (5);
- the lower distributor plate (51) and one of the clamping columns (42) serve as a forward run (60) in order to conduct the insulating liquid (6) therethrough into the cooling channels (5); and
- the upper distributor plate (50) and one of the other clamping columns (42) serve as a return run (61) in order to conduct the insulating liquid (6) therethrough out of the cooling channels (5).

6. Switching device (1) according to any one of the preceding claims, wherein
- the interior of the housing (2) and the cooling circuit (7) are connected together by way of an expansion tank (11).

7. Switching device (1) according to any one of the preceding claims, wherein
- the switching module (3, 3', 3") comprises four switching module columns (30); and
- in each of the switching module columns (30) one of the clamping columns (42) is provided as a forward run (60) and another one of the clamping columns (42) is provided as a return run (61).

8. Switching device (1) according to any one of the preceding claims, wherein
- the switching module columns (30) are held in the switching module (3, 3', 3") by means of a pressure distributing unit (70).

9. Switching device (1) according to any one of the preceding claims, wherein
- the switching device (1) is an on-load tap changer for voltage regulation at a tapped transformer with a regulating winding.

## Revendications

1. Installation de commutation (1) sous la forme d'un commutateur à plots comprenant :
- un boîtier (2),
- un module de commutation (3, 3', 3") logé à l'intérieur du boîtier (2) et comportant plusieurs éléments de commutation (4) et des boîtes de refroidissement (20) avec des canaux de refroidissement (5), intégrés, les canaux de refroidissement des différentes boîtes de refroidissement (20) étant reliés entre eux en liaison hydraulique par des conduites (18),
- un liquide isolant (6) à l'intérieur du boîtier (2) entourant le module de commutation (3, 3', 3"),
- un circuit de refroidissement (7) comportant une pompe (8), les canaux de refroidissement (5) et un échangeur de chaleur (10),
installation dans laquelle :
- l'intérieur du boîtier (2) et le circuit de refroidissement (7) sont reliés en liaison hydraulique pour que le liquide isolant (6) serve à la fois dans le circuit de refroidissement (7) pour refroidir le module de commutation (3, 3', 3") et aussi à l'intérieur du boîtier (2) comme agent isolant.

2. Installation de commutation (1) selon la revendication précédente, dans laquelle :
- les boîtes de refroidissement (20) et l'élément de commutation (4) sont reliés en conduction thermique.

3. Installation de commutation (1) selon la revendication précédente, dans laquelle :
- le module de commutation (3, 3', 3") comporte une colonne de module (30),
- la colonne de modules (30) comporte plusieurs boîtes de refroidissement (20) et éléments de commutation (4) superposés et reliés en conduction thermique.

4. Installation de commutation (1) selon la revendication précédente, dans laquelle :
- la colonne de modules (30) est située entre une plaque supérieure de précontrainte (15) et une plaque inférieure de précontrainte (16).

5. Installation de commutation (1) selon la revendication précédente, dans laquelle :
- la plaque supérieure de précontrainte (15) et la plaque inférieure de précontrainte (16) sont reliées mécaniquement par des tirants (42),
- les tirants (42) sont creux,
- une plaque supérieure de distribution (50) prévue sur la plaque supérieure de précontrainte (15) est reliée mécaniquement à celle-ci,
- une plaque inférieure de distribution (51) prévue sous la plaque inférieure de précontrainte (16) est reliée mécaniquement à celle-ci,
- les tirants (42) sont reliés en liaison hydraulique aux canaux de refroidissement (5),
- la plaque inférieure de distribution (51) et l'un des tirants (42) forment un circuit amont (60) pour le passage de liquide isolant (6) dans les canaux de refroidissement (5),
- la plaque supérieure de distribution (50) et un autre tirant (42) forment un circuit de retour (61) pour la sortie du liquide isolant (6) des canaux de refroidissement (5).

6. Installation de commutation (1) selon la revendication précédente, dans laquelle :
- l'intérieur du boîtier (2) et le circuit de refroidissement (7) sont reliés par un dispositif d'expansion (11).

7. Installation de commutation (1) selon la revendication précédente, dans laquelle :
- le module de commutation (3, 3', 3") comporte quatre colonnes de modules (30),
- chaque colonne de modules (30) comporte un tirant (42) comme circuit amont (60) et un autre tirant (42) comme circuit de retour (61).

8. Installation de commutation (1) selon la revendication précédente, dans laquelle :
- les colonnes de module (30) sont maintenues par une unité de répartition de pression (70) dans le module de commutation (3, 3', 3").

9. Installation de commutation (1) selon la revendication précédente, dans laquelle :
- l'installation de commutation (1) est un commutateur de prises en charge pour réguler la tension dans un transformateur de réglage comportant un bobinage de réglage.
